# EUROPÄISCHE PATENTSCHRIFT

(11) **EP 1 138 120 B1**
(45) Veröffentlichungstag und Bekanntmachung des Hinweises auf die Patenterteilung: **03.07.2002**
(21) Anmeldenummer: 99967870.9
(22) Anmeldetag: 08.12.1999
(51) Int. Cl.: H03M 3/02

(54) **ANALOG-DIGITAL-UMSETZER**
ANALOG-DIGITAL CONVERTER
CONVERTISSEUR ANALOGIQUE-NUMERIQUE

(30) Priorität: 10.12.1998 DE 19857042
(43) Veröffentlichungstag der Anmeldung: 04.10.2001
(73) Patentinhaber: Infineon Technologies AG, 81669 München (DE)
(72) Erfinder: HAUPTMANN, Jörg, A-9241 Wernberg (AT); SCHRANZ, Christian, A-9500 Villach (AT)
(74) Vertreter: Reinhard - Skuhra - Weise & Partner
(86) Internationale Anmeldenummer: DE9903927
(87) Internationale Veröffentlichungsnummer: WO0035096

(56) Entgegenhaltungen:
- EP-A- 0 762 656
- US-A- 5 248 971

## Beschreibung

Die Erfindung betrifft einen Analog-Digital-Umsetzer.

Die EP-A-0 762 656 offenbart einen Analog-Digital-Umsetzer, der nach dem Sigma-Delta-Prinzip arbeitet und eine Vielzahl von Eingangssignalen im Zeitmultiplex verarbeiten kann. Der Wandler enthält einen 1-Bit-Analog-Digital-Wandler, einen Ein-Bit-Digital-Analog-Wandler sowie eine einzige Integratorschaltung. Eine Vielzahl von Eingangssignalen wird der Integratorschaltung über einen Multiplexer zugeführt. Die analoge Integratorschaltung enthält eine Vielzahl von Kapazitäten entsprechend der Vielzahl von Eingangssignalen. Die Kapazitäten werden indirekt zwischen einen Eingang und einen Ausgang eines Operationsverstärkers geschaltet. Das Ausgangssignal des 1-Bit-Digital-Analog-Umsetzers wird verzögert auf den Eingang der Integratorschaltung zurückgeführt. Die Verzbgerung um eine Periode entspricht den zwei Eingangssignalen der Schaltung.

Analog-Digital-Umsetzer, die nach dem Sigma-Delta-Verfahren arbeiten, erzeugen aus einem mehrfach uberabgetasteten analogen Eingangssignal einen 1-Bit-Datenstrom. Ein Sigma-Delta-Analog-Digital-Umsetzer erster Ordnung weist eine Rückkoppelungsstruktur auf, bei der das digitale Ausgangssignal über einen Digital-Analog-Umsetzer auf einen Summierer negativ rückgekoppelt wird. Der Summierer zieht vom überabgetasteten analogen Eingangssignal das rückgekoppelte analoge Signal ab, integriert das Differenzsignal mit einer analogen Integratorschaltung und setzt das Ausgangssignal der analogen Integratorschaltung über einen 1-Bit-Analog-Digital-Wandler in ein digitales Ausgangssignal um. Sigma-Delta-Analog-Digital-Umsetzer n-ter Ordnung weisen n in Reihe geschaltete analoge Integratorschaltungen auf, wobei das Rückkoppelsignal an den Eingang jeder n Integratorschaltungen geführt wird.

In "The Design of Sigma-Delta Modulation Analog-to-Digital Converters", B.E.Boser, B.A.Wooley, IEEE Journal of Solid-State Circuits, vol.SC-23, pp. 1298-1308, December 1988, sind die Grundprinzipien der Sigma-Delta-A/D-Umsetzung beschrieben und in Figur 10 das Schaltbild eines Sigma-Delta-A/D-Umsetzers zweiter Ordnung dargestellt, der ein differentielles analoges Eingangssignal in ein digitales Ausgangssignal wandelt.

In "A 14-Bit 80-kHz Sigma-Delta A/D Converter: Modeling, Design and Performance Evaluation", S.R.Norsworthy, I.G.Post, H.S.Fetterman, IEEE Journal of Solid-State Circuits, vol.SC-24, pp.256-266, April 1989, ist ebenfalls in Figur 6 das Schaltbild eines Sigma-Delta-A/D-Umsetzers zweiter Ordnung dargestellt.

Da ein Sigma-Delta-Umsetzer eine Rückkopplung und innere Zustandsspeicher aufweist und für einen geringen Umsetzungsfehler einschwingen muß, ist die Verarbeitung einer Vielzahl von Eingangssignalen, die dem Umsetzer im Zeitmultiplex zugeführt werden, problematisch.

Aus US 5,627,536 ist ein Sigma-Delta-Analog-Digital-Umsetzer für die Umsetzung einer Vielzahl von im Zeitmultiplex zugeführten Signalen bekannt. Vor jedem umzusetzenden analogen Abtastwert müssen die inneren Zustandsspeicher des Umsetzers zurückgesetzt werden und der Umsetzer muß zur Umsetzung jedes Abtastwerts erneut einschwingen. Nachteilig ist dabei, daß dadurch die Umsetzrate des Sigma-Delta-Analog-Digital-Umsetzers vermindert wird.

Das der Erfindung zugrundeliegende technische Problem liegt daher darin, einen Sigma-Delta-Analog-Digital-Umsetzer anzugeben, der eine Vielzahl Eingangssignalen, die dem Umsetzer im Zeitmultiplex zugeführt werden, verarbeiten kann und dabei die Umsetzrate nicht durch Einschwingzeiten des Sigma-Delta-Analog-Digital-Umsetzers vermindert wird.

Dieses Problem wird durch einen Sigma-Delta-Analog-Digital-Umsetzer mit den Merkmalen von Patentanspruch 1 gelöst. Vorteilhafte Ausgestaltungen des Sigma-Delta-Analog-Digital-Umsetzers ergeben sich aus den jeweiligen Unteransprüchen.

Ein Analog-Digital-Umsetzer weist eine Vielzahl von Integratorschaltungen, einen 1-Bit-Analog-Digital-Umsetzer und einen 1-Bit-Digital-Analog-Umsetzer auf. Die Vielzahl von analogen Integratorschaltungen sind in Reihe geschaltet und der letzten analogen Integratorschaltung der Reihe ist der 1-Bit-Analog-Digital-Umsetzer nachgeschaltet. Ein Ausgangssignal des 1-Bit-Analog-Digital-Umsetzers wird dem 1-Bit-Digital-Analog-Umsetzer zugeführt und ein Ausgangsignal des 1-Bit-Digital-Analog-Umsetzers wird von einem Eingangssignal jeder analogen Integratorschaltung subtrahiert. Der ersten analogen Integratorschaltung der in Reihe geschalteten analogen Integratorschaltungen wird eine Vielzahl von Eingangssignalen über einen Multiplexer zugeführt und jede analoge Integratorschaltung weist eine Vielzahl von Kapazitäten entsprechend der Vielzahl von Eingangssignalen auf. Dabei ist jeweils eine Kapazität der Vielzahl von Kapazitäten zwischen einen Ausgang und einen Eingang eines Operationsverstärkers in jeder analogen Integratorschaltung schaltbar, so daß eine Rückkoppelkapazität gebildet wird. Das Ausgangssignal des 1-Bit-Digital-Analog-Umsetzers wird entsprechend der Vielzahl von Eingangssignalen verzögert. Vorteilhafterweise bilden die Vielzahl von Kapazitäten jeder analogen Integratorschaltung Zustandsspeicher. Jedem Eingangssignal der Vielzahl von Eingangssignalen ist in jeder analogen Integratorschaltung eine Kapazität der Vielzahl von Kapazitäten zugeordnet. Der Analog-Digital-Umsetzer kann auch für differentielle Eingangssignale ausgelegt sein. In diesem Fall sind jedem differentiellen Eingangssignal der Vielzahl von differentiellen Eingangssignalen zwei Kapazitäten zugeordnet, so daß jede analoge Integratorschaltung insgesamt doppelt so viele Kapazitäten wie die Vielzahl von differentiellen Eingangssignalen aufweist. Ein weiterer Vorteil der Erfindung ist der verringerte schaltungstechnische Aufwand zur Verarbeitung einer Vielzahl von Eingangssignalen, da anstelle einer Vielzahl von Sigma-Delta-Analog-Digital-Umsetzern enstsprechend der Vielzahl von Eingangssignalen nur jeweils in jeder analogen Integratorschaltung eine Vielzahl von Kapazitäten entsprechend der Vielzahl von Eingangssignalen vorgesehen wird. Vorteilhafterweise wird dadurch Chipfläche bei einer Integration des Sigma-Delta-Analog-Digital-Umsetzers auf einem Chip gespart.

Erfindungsgemäß wird das Ausgangssignal des 1-Bit-Digital-Analog-Umsetzers durch ein Schieberegister verzögert, wobei das Schieberegister eine Vielzahl von Ausgängen entsprechend der Vielzahl von analogen Integratorschaltungen aufweist. Jeder der Vielzahl von Ausgängen wird jeweils einem Eingang einer der Vielzahl von analogen Integratorschaltungen zugeführt, so daß einer analogen Integratorschaltung das korrekte Ausgangssignal des 1-Bit-Digital-Analog-Wandlers zugeführt wird.

Erfindungsgemäß wird das Schieberegister von einem Taktsignal getaktet, das zudem parallel eine Vielzahl von Abtastschaltern taktet. Jeder analogen Integratorschaltung sind Abtastschalter vorgeschaltet, und mit dem Taktsignal wird jeweils in jeder analogen Integratorschaltung eine Kapazität der Vielzahl von Kapazitäten zwischen zwischen einen Ausgang und einen Eingang des Operationsverstärkers geschaltet. Das Taktsignal steuert somit den Ablauf der Umsetzung der Vielzahl von Eingangssignalen.

In einer weiteren besonders bevorzugten Ausführungsform ist jeder der Vielzahl von Ausgängen des Schieberegisters um eine Taktperiode des Taktsignals untereinander verzögert. Somit liegen an jedem Ausgang des Schieberegisters zu verschiedenen Eingangssignalen gehörige Signale an.

Ein erster Ausgang der Vielzahl von Ausgängen des Schieberegisters ist in einer besonders bevorzugten Ausführungsform des Schieberegisters um Taktperioden entsprechend der um Eins verminderten Anzahl der Eingangssignale verzögert und jeder weitere Ausgang der Vielzahl von Ausgängen des Schieberegisters ist um jeweils eine weitere Taktperiode verzögert.

In einer besonders bevorzugten Ausführungsform weist die Vielzahl von Kapazitäten in jeder analogen Integratorschaltung jeweils gleiche Kapazitätswerte auf. Vorteilhafterweise läßt sich bei integrierten Schaltungen das Verhältnis im Gegensatz zu den absoluten Werten von Kapazitäten sehr viel genauer einstellen und zudem ist bei gleichen Kapazitätswerten die Integrationszeitdauer für jedes Eingangssignal gleich. In einer bevorzugten Ausführungsform wird der Verstärkungsfaktor jeder analogen Integratorschaltung durch das Verhältnis einer dem Eingang des Operationsverstärkers vorgeschalteten Kapazität und einer Kapazität der Vielzahl von Kapazitäten bestimmt.

In einer besonders bevorzugten Ausführungsform beträgt der Verstärkungsfaktor jeder analogen Integratorschaltung 0,5.

In einer bevorzugten Ausführungsform sind die Kapazitätswerte der Vielzahl von Kapazitäten der ersten analogen Integratorschaltung größer als die Kapazitätswerte der Vielzahl von Kapazitäten der weiteren analogen Integratorschaltungen.

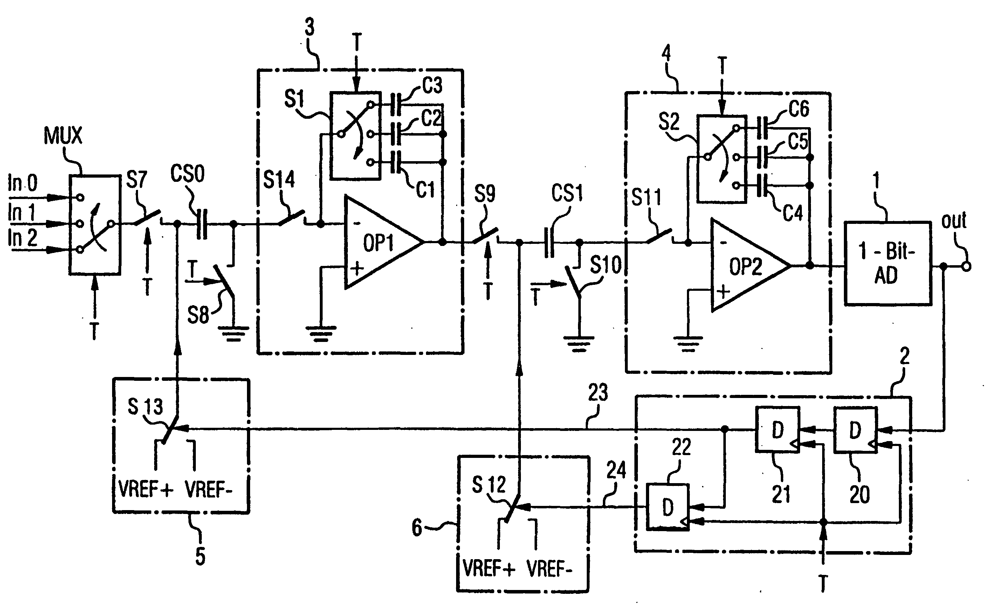

Weitere Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigt
- Fig.1: ein Ausführungsbeispiel eines Sigma-Delta-A/D-Umsetzers nach der Erfindung für die Umsetzung dreier analoger Eingangssignale.

In Figur 1 ist ein Sigma-Delta-Analog-Digital-Umsetzer dargestellt, der in Switched-Capacitor-Technik aufgebaut ist.

Einem Multiplexer MUX wird ein erstes analoges Eingangssignal In0, ein zweites analoges Eingangssignal Inl und ein drittes analoges Eingangssignal In2 zugeführt. Die drei analogen Eingangssignale müssen auf mindestens die halbe Abtastfrequenz, mit der der Sigma-Delta-Analog-Digital-Umsetzer arbeitet, bandbegrenzt sein. Auf einen Ausgang des Multiplexers MUX werden zyklisch die drei Eingangssignale In0, In1 und In2 des Multiplexers mit einem Taktsignal T geschaltet. Am Ausgang des Multiplexers liegt somit ein Signal, das Zeitschlitze mit einer Dauer entsprechend der Periodendauer des Taktsignals T aufweist und aus dem ersten analogen Eingangssignal In0, dem zweiten analogen Eingangssignal In1 und dem dritten analogen Eingangssignal In2 gebildet ist.

Das Ausgangssignal des Multiplexers wird mit einem ersten Abtastschalter S7 und einem dritten Abtastschalter S8 abgetastet. Zwischen den ersten Abtastschalter S7 und den dritten Abtastschalter S8 ist ein erster Kondensator CS0 geschaltet. Der erste Kondensator CS0 wird bei geschlossenem ersten S7 und dritten S8 Abtastschalter durch das Ausgangssignal des Multiplexers MUX geladen. Sowohl der erste S7 als auch der dritte S8 Abtastschalter wird von dem Taktsignal T gesteuert.

Ein an einem Ausgang der ersten analogen Integratorschaltung 3 anliegendes Signal wird über einen zweiten Abtastschalter S9 und einen vierten Abtastschalter S10 abgetastet. Zwischen den zweiten Abtastschalter S9 und den vierten Abtastschalter S10 ist ein zweiter Kondensator CS1 geschaltet. Der zweite Kondensator CS1 wird bei geschlossenem zweiten S9 und vierten S10 Abtastschalter durch das Ausgangssignal der ersten analogen Integratorschaltung 3 geladen. Der zweite S9 als auch der vierte S10 Abtastschalter wird von dem Taktsignal T gesteuert.

Das Ausgangssignal der zweiten analogen Integratorschaltung 4 wird einem Einbit-Analog-Digital-Umsetzer 1 zugeführt. Der 1-bit-Analog-Digital-Umsetzer 1 setzt das zugeführte abgetastete Signal in einen 1-Bit-Datenstrom um. Üblicherweise besteht der Einbit-Analog-Digital-Umsetzer aus einer einfachen Komparatorschaltung.

Der 1-Bit-Datenstrom wird einem Schieberegister 2 zugeführt. Das Schieberegister 2 verzögert den 1-Bit-Datenstrom um Taktperioden entsprechend der Vielzahl von Eingangssignalen. Das Schieberegister weist ein erstes Register 20, ein zweites Register 21 und ein drittes Register 22 auf, die von dem Taktsignal T gesteuert werden. Das erste Register 20 empfängt den 1-Bit-Datenstrom von dem 1-Bit-Analog-Digital-Umsetzer 1. Dem ersten Register 20 ist das zweite Register 21 nachgeschaltet. Durch das erste 20 und zweite 21 Register wird der 1-Bit-Datenstrom um zwei Takte des Taktsignals T verzögert. Der Ausgang des zweiten Registers 21 bildet einen ersten Ausgang 23 des Schieberegisters 2. Dem zweiten Register 21 ist parallel zu dem ersten Ausgang 23 das dritte Register 22 nachgeschaltet, dessen Ausgang wiederum einen zweiten Ausgang 24 des Schieberegisters 2 bildet.

Der erste Ausgang 23 des Schieberegisters 2 wird einem ersten Umschalter 5 zugeführt. Der zweite Ausgang 24 des Schieberegisters 2 wird einem zweiten Umschalter 6 zugeführt.

Der erste Umschalter 5 weist einen dritten Schalter S13 auf, der einen Ausgang des ersten Umschalters 5 auf eine erste Referenzspannung Vref+ oder eine zweite Referenzspannung Vref- schaltet.

Der zweite Umschalter 6 weist einen zweiten Schalter S12 auf, der einen Ausgang des zweiten Umschalters 6 auf die erste Referenzspannung Vref+ oder die zweite Referenzspannung Vref- schaltet.

Der erste 5 und zweite 6 Umschalter bilden jeweils einen 1-Bit-Digital-Analog-Wandler. Der erste Umschalter 5 wird durch den um zwei Takte des Taktsignals T verzögerten 1-Bit-Datenstrom des 1-Bit-Analog-Digital-Umsetzers 1 gesteuert. Der zweite Umschalter 6 wird durch den um drei Takte des Taktsignals T verzögerten 1-Bit-Datenstrom des 1-Bit-Analog-Digital-Umsetzers 1 gesteuert.

Ein am Ausgang des ersten Umschalters 5 anliegendes Signal wird dem Eingang der ersten analogen Integratorschaltung 3 zugeführt. Ein Ausgangssignal am Ausgang des zweiten Umschalters 6 wird der zweiten analogen Integratorschaltung 4 zugeführt.

Die erste analoge Integratorschaltung 3 weist einen ersten Operationsverstärker OP1 auf. Einem invertierenden Eingang des ersten Operationsverstärkers OP1 ist ein vierter Schalter S14 vorgeschaltet, der den Eingang der ersten analogen Integratorschaltung 3 bildet. Ein nichtinvertierender Eingang des ersten Operationsverstärkers OP1 ist mit dem Bezugspotential VSS verbunden. Ein Ausgang des ersten Operationsverstärkers OP1 bildet den Ausgang der ersten analogen Integratorschaltung. Der Ausgang des ersten Operationsverstärkers OP1 ist mit dem nichtinvertierenden Eingang des ersten Operationsverstärkers OP1 über einen dritten Umschalter S1 und einer von . drei Kapazitäten C1, C2 und C3 verbindbar. Der dritte Umschalter S1, der ein Multiplexer ist, schaltet dabei eine der drei Kapazitäten C1, C2 oder C3 zwischen den Ausgang des ersten Operationsverstärkers OP1 und den nichtinvertierenden Eingang des ersten Operationsverstärkers OP1 und wird von dem Taktsignal T gesteuert. Dadurch ist jeweils eine der drei Kapazitäten als Rückkoppelkapazität des Operationsverstärkers schaltbar.

Die zweite analoge Integratorschaltung 4 weist einen zweiten Operationsverstärker OP2 auf. Einem invertierenden Eingang des zweiten Operationsverstärkers OP2 ist ein erster Schalter S11 vorgeschaltet, der den Eingang der zweiten analogen Integratorschaltung 4 bildet. Ein nichtinvertierender Eingang des zweiten Operationsverstärkers OP2 ist mit dem Bezugspotential VSS verbunden. Ein Ausgang des zweiten Operationsverstärkers OP2 bildet den Ausgang der zweiten analogen Integratorschaltung OP4. Der Ausgang des zweiten Operationsverstärkers OP2 ist mit dem nichtinvertierenden Eingang des zweiten Operationsverstärkers OP2 über einen vierten Umschalter S2 und einer von drei Kapazitäten C4, C5 und C6 verbindbar. Der vierte Umschalter S2, der ein Multiplexer ist, schaltet dabei eine der drei Kapazitäten C4, C5 oder C6 zwischen den Ausgang des zweiten Operationsverstärkers OP2 und dem nichtinvertierenden Eingang des zweiten Operationsverstärkers OP2 und wird von dem Taktsignal T gesteuert. Dadurch ist jeweils eine der drei Kapazitäten als Rückkoppelkapazität des Operationsverstärkers schaltbar.

Es sollte angestrebt werden, die drei Kapazitäten C1 bis C3 bzw. C4 bis C6 der ersten 3 bzw. zweiten 4 analogen Integratorschaltung möglichst klein zu halten, um den Ausgangsstrom des Operationsverstärkers OP1 bzw. OP2 und damit die Anstiegszeit zu minimieren. Die drei Kapazitäten C4 bis C6 der zweiten analogen Integratorschaltung 4 können kleiner als die drei Kapazitäten C1 bis C3 der ersten analogen Integratorschaltung 3 sein, da in der ersten analogen Integratorschaltung verursachtes (thermisches) Rauschen durch eine Shaping-Funktion erster Ordnung der ersten analogen Integratorschaltung verringert wird.

Jedem der drei analogen Eingangssignale In0, In1 und In2 ist dabei jeweils eine der drei Kapazitäten C1, C2 und C3 bzw. C4, C5 und C6 der ersten analogen Integratorschaltung 3 bzw. der zweiten analogen Integratorschaltung 4 zugeordnet. Die Kapazitäten C1 bis C3 bzw. C4 bis C6 bilden Zustandsspeicher für die zu integrierenden Eingangssignale der analogen Integratorschaltung.

Der Sigma-Delta-Analog-Digital-Umsetzer arbeitet nach dem Pipeline-Prinzip. Die folgende Tabelle verdeutlicht während verschiedener Perioden 1 bis 7 des Taktsignals T den Zustand der ersten analogen Integratorschaltung 3, der zweiten analogen Integratorschaltung 4 und des ersten Registers 20, des zweiten Registers 21 und des dritten Registers 22 (durch die teifgestellten Indizes wird die Taktperiode angegeben, in der das analoge Eingangssignal am Ausgang des Multiplexers MUX angelegen hat):

| *T* | 3 | 4 | 20 | 21 | 22 |
|---|---|---|---|---|---|
| 1 | In0₁ | - | - | - | - |
| 2 | In1₂ | In0₁ | - | - | - |
| 3 | In2₃ | In1₂ | In0₁ | - | - |
| 4 | In0₄ | In2₃ | In1₂ | In0₁ | - |
| 5 | In1₅ | In0₄ | In2₃ | In1₂ | In0₁ |
| 6 | In2₆ | In1₅ | In0₄ | In2₃ | In1₂ |
| 7 | In0₇ | In2₆ | In1₅ | In0₄ | In2₃ |

Bis zur Taktperiode 4 muß der Sigma-Delta-Analog-Digital-Umsetzer einschwingen, da die in der zweiten analogen Integratorschaltung 4 und dem ersten bis dritten Register 20 bis 22 gespeicherten Werte Anfangswerte sind, die nicht mit den drei analogen Eingangssignalen In0 bis In2 zusammenhängen. Ab der fünften Taktperiode ist der Sigma-Delta-Analog-Digital-Umsetzer mit Abtastwerten der analogen Eingangssignale In0 bis In2 "gefüllt". Aus der Tabelle ist ersichtlich, daß der Ausgang des zweiten Registers 21, der auf den Eingang der ersten analogen Integratorschaltung 3 zurückgeführt wird, das analoge Eingangssignal aufweist, das auch über den Multiplexer MUX dem Eingang ersten analogen Integratorschaltung 3 zugeführt wird. Dasselbe gilt für die zweite analoge Integratorschaltung 4. Die für die erste und zweite analoge Integratorschaltung angegebenen Werte beziehen sich selbstverständlich auf die Kapazität, die den Zustandsspeicher für den jeweiligen Wert bildet. Durch das Taktsignal T wird der jeweils passende Zustandsspeicher bzw. die jeweils passende Kapazität dem Operationsverstärker in der analogen Integratorschaltung zugeschaltet.

Aufgrund verschiedener Parameter wie Durchlaufzeiten einzelner Komponenten, Integrationszeitkonstanten, etc. sollte das Taktsignal an die jeweils zu steuernde Komponente angepaßt werden. Beispielsweise ist darauf zu achten, daß es aufgrund von Signallaufzeiten auf den Taktleitungen des Taktsignals nicht zu Überlappungen der einzelnen Taktperioden kommt und dadurch Umsetzfehler auftreten. Ein anderes Beispiel ist die Integrationszeitdauer der analogen Integratorschaltungen, die berücksichtigt werden muß. Dabei muß die Integration eines Werte abgeschlossen sein, bevor der nächste Wert integriert wird. Dabei kann es auch erforderlich sein, die Verzögerung durch das Schiebregister beispielsweise um die Verzögerung einer halben Periode des Taktsignals zu erweitern.

Die am meisten kritische Komponente des Sigma-Delta-Analog-Digital-Umsetzers ist der in der analogen Integratorschaltung enthaltene Operationsverstärker, der sehr sorgfältig hinsichtlich der Einschwingdauer und der Anstiegszeit ausgewählt werden muß. Dabei spielt es keine Rolle, daß der Operationsverstärker eine kurze Einschwingzeit aufweist. Vielmehr muß der Operationsverstärker während der Einschwingzeit im linearen Bereich arbeiten. Die Anstiegszeit sollte dabei die Einschwingzeit nicht begrenzen.

### Bezugszeichenliste

- 1: 1-Bit-Analog-Digital-Umsetzer
- 2: Schieberegister
- 20 - 22: 1-Bit-Register
- 3: erste analoge Integratorschaltung
- 4: zweite analoge Integratorschaltung
- 5: erster Umschalter
- 6: zweiter Umschalter
- In0: erstes Eingangssignal
- In1: zweites Eingangssignal
- In2: drittes Eingangssignal
- MUX: Multiplexer
- T: Taktsignal
- S1: dritter Umschalter
- S2: vierter Umschalter
- S7: erster Abtastschalter
- S8: dritter Abtastschalter
- S9: zweiter Abtastschalter
- S10: vierter Abtastschalter
- S11: erster Schalter
- S12: zweiter Schalter
- S13: dritter Schalter
- S14: vierter Schalter
- CS0: erster Kondensator
- CS1: zweiter Kondensator
- C1 - C3: Rückkoppelkapazitäten der ersten analogen Integratorschaltung
- C4 - C6: Rückkoppelkapazitäten der zweiten analogen Integratorschaltung
- OP1: erster Operationsverstärker
- OP2: zweiter Operationsverstärker
- VSS: Bezugspotential
- Vref+: erste Referenzspannung
- Vref-: zweite Referenzspannung

## Patentansprüche

1. Analog-Digital-Umsetzer, der eine Vielzahl von analogen Integratorschaltungen (3, 4) sowie einen 1-Bit-Analog-Digital-Umsetzer (1) und einen 1-Bit-Digital-Analog-Umsetzer (5, 6) aufweist, wobei die Vielzahl von analogen Integratorschaltungen (3, 4) in Reihe geschaltet sind und der letzten analogen Integratorschaltung der Reihe der 1-Bit-Analog-Digital-Umsetzer (1) nachgeschaltet ist, wobei ein Ausgangssignal des 1-Bit-Analog-Digital-Umsetzers (1) dem 1-Bit-Digital-Analog-Umsetzer (5, 6) zugeführt wird und ein Ausgangsignal des l-Bit-Digital-Analog-Umsetzer (5, 6) von einem Eingangssignal jeder analogen Integratorschaltung (3, 4) subtrahiert wird, und wobei der ersten analogen Integratorschaltung (3) der in Reihe geschalteten analogen Integratorschaltungen (3, 4) eine Vielzahl von Eingangssignalen (In0, In1, In2) über einen Multiplexer (MUX) zugeführt wird,
wobei
- jede analoge Integratorschaltung (3, 4) eine Vielzahl von Kapazitäten (C1 - C3, C4 - C6) entsprechend der Vielzahl von Eingangssignalen (InO, In1, In2) aufweist;
- in jeder analogen Integratorschaltung (3, 4) jeweils eine Kapazität der Vielzahl von Kapazitäten zwischen einen Ausgang und einen Eingang eines Operationsverstärkers (OP1, OP2) schaltbar ist;
- das Ausgangssignal des 1-Bit-Digital-Analog-Umsetzers (5, 6) entsprechend der Vielzahl von Eingangssignalen verzögert wird;
das Ausgangssignal des l-Bit-Digital-Analog-Umsetzers durch ein Schieberegister (2) verzögert wird, wobei das Schieberegister (2) eine Vielzahl von Ausgängen (23, 24) entsprechend der Vielzahl von analogen Integratorschaltungen (3, 4) aufweist; und
das Schieberegister (2) von einem Taktsignal (T) getaktet wird und das Taktsignal (T) parallel eine Vielzahl von Abtastschaltern (S7, S8, S9, S10) taktet, die den analogen Integratorschaltungen (3, 4) vorgeschaltet sind, und mit dem Taktsignal (T) in jeder analogen Integratorschaltung (3, 4) jeweils eine Kapazität der Vielzahl von Kapazitäten (C1 - C3, C4 - C6) zwischen einen Ausgang und einen Eingang des Operationsverstärkers (OP1, OP2) geschaltet wird.

2. Analog-Digital-Umsetzer nach Anspruch 1,
**dadurch gekennzeichnet, daß**
jeder der Vielzahl von Ausgängen (23, 24) des Schieberegisters (2) um eine Taktperiode des Taktsignals (T) untereinander verzögert sind.

3. Analog-Digital-Umsetzer nach Anspruch 2,
**dadurch gekennzeichnet, daß**
ein erster Ausgang (23) der Vielzahl von Ausgängen des Schieberegisters (2) um Taktperioden entsprechend der um Eins verminderten Anzahl der Eingangssignale (In0, In1, In2) verzögert ist und jeder weitere Ausgang (24) der Vielzahl von Ausgängen des Schieberegisters (2) um jeweils eine weitere Taktperiode verzögert ist.

4. Analog-Digital-Umsetzer nach einem der vorhergehenden Ansprüche,
**dadurch gekennzeichnet, daß**
die Vielzahl von Kapazitäten (C1 - C3, C4 - C6) in jeder analogen Integratorschaltung (3, 4) jeweils gleiche Kapazitätswerte aufweisen.

5. Analog-Digital-Umsetzer nach einem der vorhergehenden Ansprüche,
**dadurch gekennzeichnet, daß**
der Verstärkungsfaktor jeder analogen Integratorschaltung (3, 4) durch das Verhältnis einer dem Eingang des Operationsverstärkers (OP1, OP2) vorgeschalteten Kapazität (CS0, CS1) und einer Kapazität der Vielzahl von Kapazitäten (C1 - C3, C4 - C6) bestimmt wird.

6. Analog-Digital-Umsetzer nach Anspruch 5,
**dadurch gekennzeichnet, daß**
der Verstärkungsfaktor jeder analogen Integratorschaltung (3, 4) 0,5 beträgt.

7. Analog-Digital-Umsetzer nach einem der vorhergehenden Ansprüche,
**dadurch gekennzeichnet, daß**
die Kapazitätswerte der Vielzahl von Kapazitäten (C1 - C3) der ersten analogen Integratorschaltung (3) größer sind als die Kapazitätswerte der Vielzahl von Kapazitäten (C4 - C6) der weiteren analogen Integratorschaltungen (4).

## Claims

1. Analogue/digital converter which has a multiplicity of analogue integrator circuits (3, 4) and also a 1-bit analogue/digital converter (1) and a 1-bit digital/analogue converter (5, 6), where the multiplicity of analogue integrator circuits (3, 4) are connected in series, and the 1-bit analogue/digital converter (1) is connected downstream of the last analogue integrator circuit in the series, where an output signal from the 1-bit analogue/digital converter (1) is supplied to the 1-bit digital/analogue converter (5, 6), and an output signal from the 1-bit digital/analogue converter (5, 6) is subtracted from an input signal of each analogue integrator circuit (3, 4), and where a multiplicity of input signals (In0, In1, In2) are supplied via a multiplexer (MUX) to the first analogue integrator circuit (3) from the analogue integrator circuits (3, 4) connected in series,
**characterized in that**
- each analogue integrator circuit (3, 4) has a multiplicity of capacitances (C1-C3, C4-C6) in accordance with the multiplicity of input signals (In0, In1, In2);
- in each analogue integrator circuit, a respective capacitance from the multiplicity of capacitances can be connected between an output and an input of an operational amplifier (OP1, OP2);
- the output signal from the 1-bit digital/analogue converter (5, 6) is delayed in accordance with the multiplicity of input signals;
- the output signal from the 1-bit digital/analogue converter is delayed by a shift register (2), the shift register (2) having a multiplicity of outputs (23, 24) in accordance with the multiplicity of analogue integrator circuits (3, 4); and
**in that** the shift register (2) is clocked by a clock signal (T), and the clock signal (T) clocks, in parallel, a multiplicity of sampling switches (S7, S8, S9, S10) which are connected upstream of the analogue integrator circuits (3, 4), and the clock signal (T) causes a respective capacitance from the multiplicity of capacitances (C1-C3, C4-C6) to be connected between an output and an input of the operational amplifier (OP1, OP2) in each analogue integrator circuit (3, 4).

2. Analogue/digital converter according to Claim 1,
**characterized in that**
the multiplicity of outputs (23, 24) of the shift register (2) are each delayed with respect to one another by one clock period of the clock signal (T).

3. Analogue/digital converter according to Claim 2,
**characterized in that**
a first output (23) from the multiplicity of outputs of the shift register (2) is delayed by clock periods in accordance with the number of input signals (In0, In1, In2) reduced by one, and each further output (24) from the multiplicity of outputs of the shift register (2) is delayed by one respective further clock period.

4. Analogue/digital converter according to one of the preceding claims,
**characterized in that**
the multiplicity of capacitances (C1-C3, C4-C6) in each analogue integrator circuit (3, 4) have respective identical capacitance values.

5. Analogue/digital converter according to one of the preceding claims,
**characterized in that**
the gain factor of each analogue integrator circuit (3, 4) is determined by the ratio of a capacitance (CS0, CS1) connected upstream of the input of the operational amplifier (OP1, OP2) and a capacitance from the multiplicity of capacitances (C1-C3, C4-C6).

6. Analogue/digital converter according to Claim 5,
**characterized in that**
the gain factor of each analogue integrator circuit (3, 4) is 0.5.

7. Analogue/digital converter according to one of the preceding claims,
**characterized in that**
the capacitance values of the multiplicity of capacitances (C1-C3) in the first analogue integrator circuit (3) are larger than the capacitance values of the multiplicity of capacitances (C4-C6) in the other analogue integrator circuits (4).

## Revendications

1. Convertisseur analogique-numérique, présentant une pluralité de circuits intégrateurs (3, 4) analogiques, ainsi qu'un convertisseur analogique-numérique à 1 bit (1) et un convertisseur numérique-analogique à 1 bit (5, 6), la pluralité de circuits intégrateurs (3, 4) analogiques étant branchée en série et le convertisseur analogique-numérique à 1 bit (1) est installé en aval du dernier circuit intégrateur analogique de la série, un signal de sortie du convertisseur analogique-numérique à 1 bit (1) étant amené au convertisseur numérique-analogique à 1 bit (5, 6) et un signal de sortie du convertisseur numérique-analogique à 1 bit (5, 6) étant soustrait d'un signal d'entrée de chaque circuit intégrateur analogique (3, 4), et une pluralité de signaux d'entrée (In0, In1, In2) étant amenée, par l'intermédiaire d'un multiplexeur (MUX), au premier circuit intégrateur (3) analogique des circuits intégrateurs (3, 4) analogiques branchés en série, où
- chaque circuit intégrateur analogique (3, 4) présente une pluralité de capacités (C1 à C3, C4 à C6) correspondant à la pluralité des signaux d'entrée (In0, In1, In2) ;
- dans chaque circuit intégrateur analogique (3, 4), une capacité, appartenant à la pluralité des capacités, est chaque fois susceptible d'être branchée entre une sortie et une entrée d'un amplificateur opérationnel (OP1, OP2) ;
- le signal de sortie du convertisseur numérique-analogique à 1 bit (5, 6) est retardé de manière correspondante à la pluralité des signaux d'entrée ;
- le signal de sortie du convertisseur numérique-analogique à 1 bit est retardé par un registre à décalage (2), le registre à décalage (2) présentant une pluralité de sorties (23, 24) correspondant à la pluralité des circuits intégrateurs analogiques (3, 4); et
le registre à décalage (2) est cadencé par un signal de cadencement (T) et le signal de cadencement (T) cadence, parallèlement, une pluralité d'interrupteurs d'échantillonnage (S7, S8, S9, S10) branchés en amont des circuits intégrateurs analogiques (3, 4), et avec le signal de cadencement (T) dans chaque circuit intégrateur analogique (3, 4) est chaque fois branchée une capacité appartenant à la pluralité des capacités (C1 à C3, C4 à C6) entre une sortie et une entrée de l'amplificateur opérationnel (OP1, OP2).

2. Convertisseur analogique-numérique selon la revendication 1, **caractérisé en ce que** chacune de la pluralité des sorties (23, 24) du registre à décalage (2) sont retardées entre elles, de la valeur d'une période de cadencement du signal de cadencement (T).

3. Convertisseur analogique-numérique selon la revendication 2, **caractérisé en ce qu'**une première sortie (23) de la pluralité des sorties du registre à décalage (2) est retardée de périodes de cadencement correspondant à la valeur du nombre, diminué de un, des périodes de cadencement des signaux d'entrée (In0, In1, In2) et chaque autre sortie (24) de la pluralité des sorties du registre à décalage (2) est respectivement retardée de la valeur d'une période de cadencement supplémentaire.

4. Convertisseur analogique-numérique selon l'une des revendications précédentes, **caractérisé en ce que** la pluralité des capacités (C1 à C3, C4 à C6) dans chaque circuit intégrateur analogique (3, 4) présentent chaque fois des valeurs de capacités identiques.

5. Convertisseur analogique-numérique selon l'une des revendications précédentes, **caractérisé en ce que** le facteur d'amplification de chaque circuit intégrateur analogique (3, 4) est déterminé par le rapport entre une capacité (CS0, CS1), branchée en amont de l'entrée de l'amplificateur opérationnel (OP1, OP2), et une capacité de la pluralité des capacités (C1 à C3, C4 à C6).

6. Convertisseur analogique-numérique selon la revendication 5, **caractérisé en ce que** le facteur d'amplification de chaque circuit intégrateur analogique (3, 4) est de 0,5.

7. Convertisseur analogique-numérique selon l'une des revendications précédentes, **caractérisé en ce que** les valeurs de capacité de la pluralité de capacités (C1 à C3) du premier circuit intégrateur analogique (3) sont supérieures aux valeurs de capacité de la pluralité des capacités (C4 à C6) des autres circuits intégrateurs analogiques (4).
